Europäisches Patentamt

European Patent Office

Office européen des brevets

(11) Publication number:

**0 385 567**
**A2**

# EUROPEAN PATENT APPLICATION

(21) Application number: 90300501.5

(22) Date of filing: 18.01.90

(51) Int. Cl.5 **G06F 1/08**

(30) Priority: 28.02.89 GB 8904583

(43) Date of publication of application:
05.09.90 Bulletin 90/36

(84) Designated Contracting States:
DE FR GB

(71) Applicant: **International Business Machines**
**Corporation**
**Old Orchard Road**
**Armonk, N.Y. 10504(US)**

(72) Inventor: **Homewood, Brian Clive**

7 Amport Close Harestock
Winchester, Hampshire SO22 6LP(GB)
Inventor: **Buttimer, Malcolm Douglas**
**Ways Cottage, Slab Lane**
**Woodfalls, Salisbury Wiltshire SP5 2NG(GB)**
Inventor: **West, Roderick Michael Peters**
**1 Balmoral Close, North Millers Dale**
**Chandlers Ford, Hampshire, SO5 1TG(GB)**

(74) Representative: **Harris, Ian Richard**
**IBM United Kingdom Limited Intellectual**
**Property Department Hursley Park**
**Winchester, Hants. SO21 2JN(GB)**

(54) Clock signal generator for a data processing system.

(57) A clock signal generator for generating the system clock signal 24 for the processor 12 of a data processing system has a programmable frequency generator 30, 32, 34 which can be connected to a source of a fundamental frequency and connected 38 to receive control data 36 from the processor such the frequency of the system clock signal for the processor is programmable in response to data supplied by said processor under program control. The clock signal generator also includes additional programmable frequency generators connectable to receive control data from said processor under program control for generating additional, independent, programmable clock signals. In the example described each programmable frequency generator comprises a programmable phase-locked loop 32 and one or more programmable frequency dividers 34.

FIG. 2

# CLOCK SIGNAL GENERATOR FOR A DATA PROCESSING SYSTEM

The present invention relates to a clock signal generator for generating the system clock signal for the processor of a data processing system and to a data processing system incorporating such a clock signal generator.

It is normal in the data processing arts to use a predetermined frequency for system clocking. This predetermined frequency is determined to give reliable service depending on the hardware and operating constraints of the system. Sometimes, it may be desirable to generate a number of different system clock signals for controlling the processor in various modes of operation.

EP-A-242 010 describes a clock circuit for supplying a clock signal to a data processor at a selectable one of a plurality of frequencies under the control of that processor.

WO85/02275 and WO86/00432 each describe a clock signal generator for generating the system clock signal for the processor of a data processing system, the clock signal generator comprising a programmable frequency generator which is connectable to a source of fundamental frequency for generating the system clock signal, and which is connectable to received control data from said processor under program control whereby the frequency of the system clock signal for the processor is selectable in response to data supplied by the processor under program control. The aim of the clock signal generators described in these documents is to enable the clock signal frequency to be adapted to the current processing requirements and so to reduce power consumption when a fast clock rate is not needed.

Although WO85/02275 and WO86/00432 describe clock signal generators which enable the processor to control its own clock frequency in a dynamic way, they do not provide a complete solution to enabling the accomodation of different configurations of the data processing system and/or operating conditions under which the processor is operating. For example they do not provide a solution to a situation where a plurality of independent system oscillators are needed.

Consider the situation in a workstation such as a personal computer. In particular, where a display adapter of the personal computer is intended to support a number of different monitors having different resolutions, different frequencies may be needed in order to match scan and video rates of the different monitors. In existing personal computers such as the IBM PS/2 personal computers, separate crystal oscillators are provided for each monitor to be supported as well as a separate oscillator for the system clock signal. Crystal oscillators are expensive and take up a lot of printed circuit board space.

In accordance with the invention, there is provided a clock signal generator for generating the system clock signal for the processor of a data processing system, the clock signal generator comprising a programmable frequency generator which is connectable to a source of a fundamental frequency for generating the system clock signal and which is connectable to receive control data from the processor under program control whereby the frequency of the system clock signal for the processor is selectable in response to data supplied by the processor under program control, characterised in that the clock signal generator comprises one or more additional programmable frequency generators, each additional programmable frequency generator being connectable to the source of a fundamental frequency and connectable to receive control data from said processor under program control for generating an additional independent clock signal, the frequency of each of which is selectable in response to data supplied by said processor under program control.

A clock signal generator in accordance with the present invention enables a plurality of independent clock signals can be generated, the frequency of each of which is selectable in response to data supplied by said processor under program control. If the data processing system includes a display device, the additional independent clock signals so generated can be used, for example as programmable pixel clock signals and/or programmable clock signals controlling the display device and/or for scanning display data to the display device.

Preferably, each programmable frequency generator comprises a programmable phase-locked loop for generating a primary frequency. In the preferred example of the invention, the programmable phase-locked loop comprises a voltage controlled oscillator for generating the primary frequency, a counter for counting a number of cycles of said primary frequency (which number is determined by the control data) and for generating a control pulse on counting said number of cycles and a phase comparator for comparing the phase of said control pulse to the phase of a reference frequency derived from said fundamental frequency, the phase comparator controlling the frequency of oscillation of the voltage controlled oscillator.

The primary frequency could be used directly as a clock signal. However, to avoid unstable conditions, the programmable phase-locked loop is limited to producing frequencies within one harmonic range. In order to generate sub-multiples (e.g. sub-harmonics) of the primary frequency, it is preferable that the or each programmable frequency generator comprises one or more programmable frequency dividers, each for selecting a submultiple of the primary frequency under program control. Each of the programmable frequency generators is connected to receive the primary frequency of a programmable frequency generator and to generate separate clock signal outputs for a programmable frequency divider.

Preferably, a programmable frequency divider comprises a frequency divider chain connected to receive the primary frequency for generating sub-harmonics of the primary frequency and a multiplexer, responsive to the control data for selecting one of the sub-harmonics of the primary frequency under program control as the clock signal output of the programmable frequency generator. In order to avoid possible clock errors, means are preferably provided for updating the selection of a sub-multiple of the primary frequency by the multiplexer in synchronism with the slowest sub-multiple input thereto.

For storing the control data in each programmable frequency generator, the or each programmable frequency generator preferably comprises register means.

The programmable frequency generators of the clock signal generator as defined above are preferably integrated in a single integrated circuit.

In accordance with a second aspect of the invention, there is provided a data processing system comprising a system processor and a clock signal generator as defined above. The data processing system preferably comprises control means for initially setting the programmable frequency generator for generating said system clock signal to a predetermined initial frequency on system initialization, and stored system start-up code for changing, under processor control, said initial frequency to an operating frequency.

In one example the data processing system is a display adapter for attachment of a display device to the main system bus of a workstation. In this example, the processor is a display processor and the system clock signal is the system clock signal for the display processor. In this example, the clock signal generation additionally generates programmable pixel clock signals and/or programmable clock signals controlling the display device and/or for scanning display data to the display device.

An example of the invention will be described in the following reference to the accompanying drawings in which:

Figure 1 is a block diagram of part of a data processing system including a clock signal generator in accordance with the invention;

Figure 2 is a diagram showing more details of the clock signal generator of Figure 1;

Figure 3 are timing diagrams; and

Figure 4 is an illustration of a workstation including the present invention.

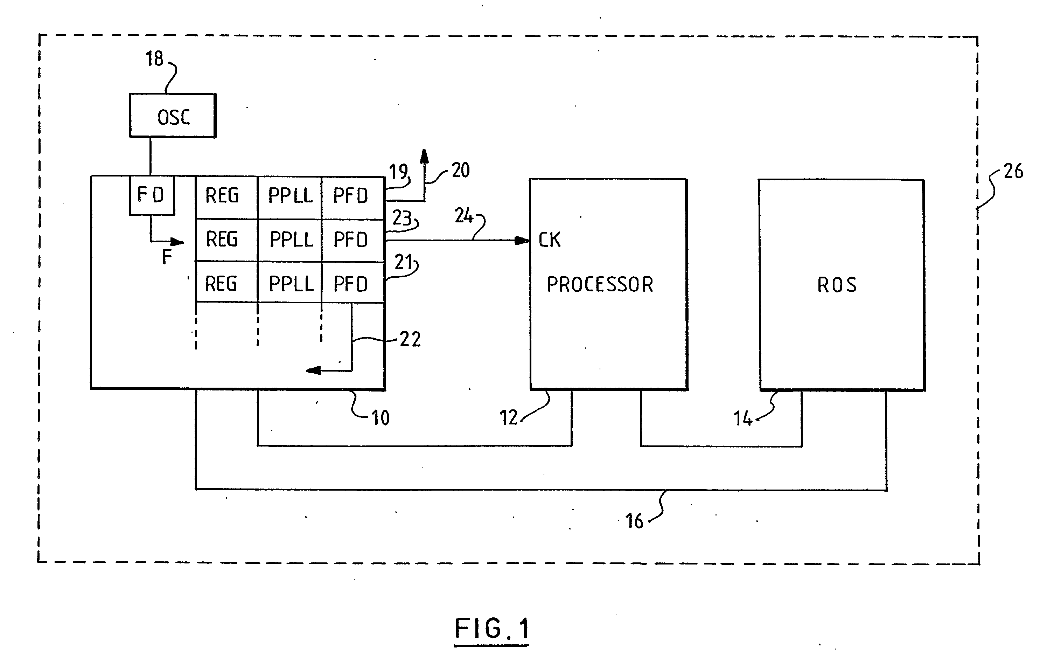

Figure 1 is a schematic block diagram of part of a data processor system comprising a clock signal generator 10, a processor 12 and a read only store (ROS) 14. The clock signal generator, the processor 12 and the ROS 14 are connected to a bus 16. Also connected to the bus 16, but now shown may be random access memory (RAM), adapters for connecting I/O devices and so on.

The clock signal generator 10 is connected to an oscillator 18 (e.g., a simple crystal), which forms a source of a basic frequency from which all of the clock signals required by the data processor system are generated. The signal from the crystal 18 is divided by a frequency divider FD into a reference frequency 'F' which is supplied to each of a plurality of programmable frequency generators 19, 21, 23, ..., etc. Each frequency generator in this example includes a phase-locked loop (PPLL) frequency generator which generates a primary frequency at a selectable frequency under program control of the processor 12. Each primary frequency is generated independently of the primary frequencies of the other PPLLs. The primary frequencies output by the PPLLs are supplied to corresponding programmable frequency divider (PFD) stages. In this example, the corresponding primary frequency is divided by a selectable multiples of 2 by the PFD of the programmable frequency generators 19, 21 and 22, respectively, to generate: clock signals (20) for controlling devices external to the circuit; clock signals (22) for controlling operations within the clock signal generator circuit 10; and the system clock signal 24 for processor 12. The PPLL and PFD stages are programmed by control data stored in corresponding registers (REG) stages by the processor 12 via the system bus 16.

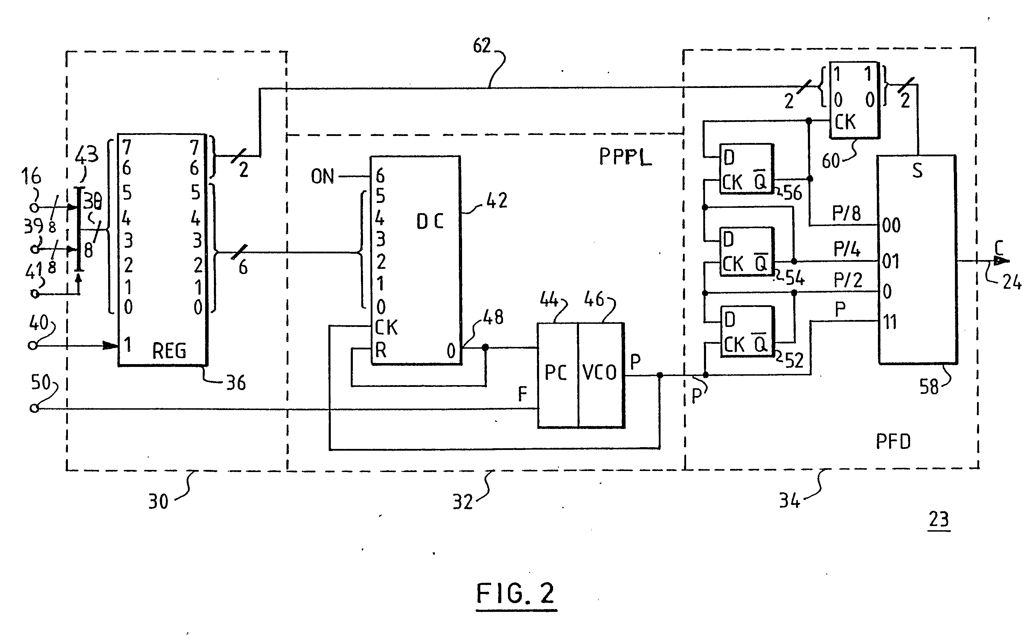

Figure 2 illustrates examples of a register (REG) stage 30, a programmable phase-locked loop (PPLL) frequency generator stage 32 and a programmable frequency divider (PFD) stage 34 for the programmable frequency generator 23 in more detail.

The register (REG) stage in this example comprises an eight bit register 36. In response to a load signal L from the processor via the bus 16 and control line 40, eight bits of data are read via data lines from the bus 16. The source of the data (which could be the ROS 14, RAM (not shown) or a register in the processor 10) is determined under program control by the processor. A multiplexer 43 is inserted between the data lines 38 and the bus 16 to permit a hardwired initial value 39 to be inserted into the register 36 at system initialisation in response to a power-on reset signal 41 for setting the programmable frequency

3

generator to an initial clock frequency. Bits 0-5 of the 8 bit data are used for controlling the primary frequency generated by the PPLL stage 32. Bits 6 and 7 are used to control the operation of the PFD stage 34.

The PPLL stage operates in the following manner. When a reload signal R is supplied to a 7-bit down-counter 42, the contents of bits 0-5 of the register 36 are loaded into bits 0-5 of down-counter 42. The data input to bit 6 of the down-counter 42 is hard-wired to logical 1 so that when the reload signal R is applied to the down-counter, bit 6 is set to logical one. On each pulse of the primary frequency 'P' (the output from a voltage controlled oscillator (VCO) 45) the down-counter 42 decrements its count. The frequency output by the voltage-controlled oscillator 46 is controlled by a phase comparator (PC) 44. The down-counter 42 continues to decrement its count on receipt of its clock input CK of each pulse of the primary frequency until it reached zero. When this occurs, a control pulse is output from the control output 48 of the down-counter 42 which forms the reload signal 'R' for reloading the down-counter. The control pulse from output 48 is also supplied to a first input of the phase comparator 44. The second input of the phase comparator 44 is connected to receive the reference frequency 'F' on line 50, from the frequency divider FD.

If the control pulse output from the down-counter 42 is not in phase with the reference frequency 'F', then the phase comparator causes the VCO 46 to tune its frequency such that when the down-counter next reaches zero the control pulse and the reference frequency should be in phase or nearer to being in phase with one another. Preferably the phase comparator 44 and the VCO 46 are arranged to operate in a manner to avoid sudden changes in the primary frequency 'P' output by the VCO. Although this means that if a large phase difference is detected, that a few cycles of the down-counter 42 may be necessary to correct the frequency 'P' this has the advantage that the PPLL stage is more stable as a result. Also, the transition between two frequencies of 'P' is achieved smoothly and without sporadic clock pulses ("glitches") being injected into the clock signal. Register 42, the phase-comparator 44 and the voltage controlled oscillator 46 need not be described in detail as these are components well know as such to the person skilled in the art.

In one example of the invention the reference frequencies 'F' on the line 50 is 1 MHz which is produced from an inexpensive 4 MHz crystal by dividing the basic 4 MHz frequency by 4 in the frequency divider FD. The voltage controlled oscillator 46 in the programmable phase locked loop formed by the VCO 46, the down-counter 12 and the phase comparator 44 is arranged to run at a frequency between 65 and 128 MHz as determined by the content of the register 36. If bits 0-5 of the register 32 are all zeros, then the content of the down-counter on each reload signal will be set to the binary value "1000000" (bit 6 is hardwired to logical 1), and the phase-locked loop will be caused to run at 65 MHz.

The output frequency of the phase locked loop frequency generator can thus be programmably set at a frequency 'P' within one harmonic (i.e., between 65 and 128 MHz). In order to enable sub-harmonics of this output frequency to be generated, the programmable frequency divider (PFD) stage 34 is provided.

As illustrated the programmable frequency divider stage 34 comprises three frequency dividers 52, 54, 56 for generating signals P/2, P/4 and P/8 respectively, although more could be provided if required. Each of the frequencies P, P/2, P/4 and P/8 is supplied to a 4:1 multiplexer 58. Two bits are supplied to the select port 5 of the multiplexer 58 for selecting one of the frequencies P, P/2, P4 and P/8 as the output clock signal 'C' from the PFD stage to form the system clock signal 24.

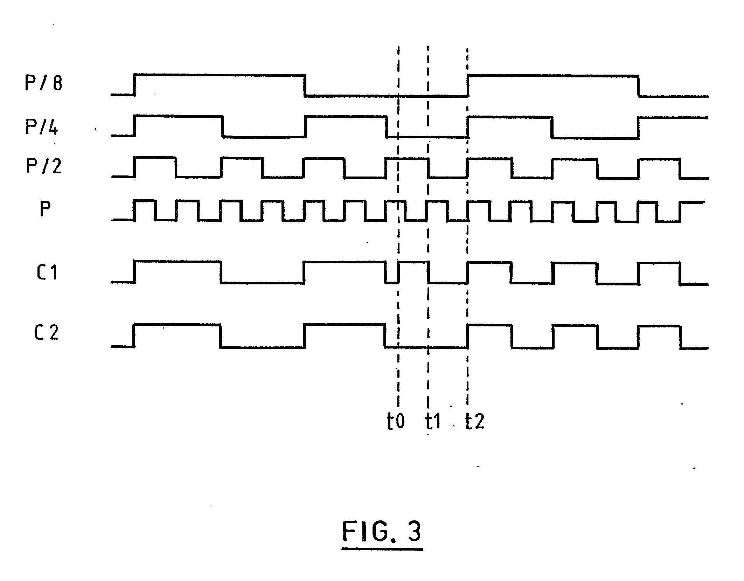

The select bits are formed from bits 6 and 7 of the control data in the register 36. These control bits are not supplied directly from the register 36, but are instead latched in a 2 bit, edge-triggered latch 60. The clock input (CK) of the latch circuit 60 is connected to receive the frequency P/8 and operates to latch the data on the select bit lines 62 from the register 36 on each positive going edge of the pulse train P/8. These select bits are latched in this manner to ensure that any change of frequency is synchronized with all of the clock signal frequencies P, P/2, P/4 and P/8 and avoids any possible glitches which might occur if changes were permitted at any other time. Figure 3 illustrates the difference that the latch 60 makes when changing frequencies. The first four pulse trains are P/8, P/4, P/2 and P respectively. The fifth pulse train C1 represents a C pulse train which would be generated if the select bits on lines 62 were applied directly to the S port of the multiplexer 58. It is assumed that initially the contents of bits 7 and 6 the register 36 were 0 and 1 respectively so that the P/4 pulse train is selected by the multiplexer 58. However, at time $t_o$, the output of bits 7 and 6 of the register 36 are changed to 1 and 0 respectively so that now P/2 is selected. It can be seen that an extra irregular pulse is generated between times $t_o$ and $t_i$ in the pulse train C1.

Pulse train $C_2$ illustrates how the latch 60 avoids this problem in that the new data in the register 36, although available at $t_o$ is only latched into the register 60 at $t_1$. At $t_2$, all of the pulse trains are positive going and accordingly at this time glitch-free frequency changes can be made using the frequency divider.

The frequencies shown in Table 1 can be generated by means of the combination of the PPLL 32 and the PFD 34 for the following values of bits 7-6 of register 36, depending on the values in bits 5-0 of register 36.

TABLE 1

| Bits 7-6 | C | Frequencies |
|---|---|---|
| 00 | P/8 | 8.125 - 16.00 MHz in 0.125 MHz steps |
| 01 | P/4 | 16.25 - 32.00 MHz in 0.25 MHz steps |
| 10 | P/2 | 32.50 - 64.00 MHz in 0.5 MHz steps |
| 11 | P | 65.00 - 128.00 MHz in 1 MHz steps |

The clock signal generator described above is of general application and can be used for programmably generating all the clock signals in a data processing system.

At power-up time, a power-on reset signal 41 is supplied to the multiplexer 43 for gating a hardwired initial value 39 via the data lines 38 (instead of a value from the bus 16) into the registers 36. This is used to set the phase-locked loop frequency generator stage to an initial frequency. Preferably the value 01000000 is loaded into the register 36 for controlling the frequency of the processor clock signal 24 so that the processor operates at a relatively low initial frequency of 16.25 MHz. This avoids possible unstable conditions. The processor, under control of the system start-up code can then increase its clock signal to a desired initial operating clock signal frequency. The start-up code is stored in the ROS 14. The initial operating frequency can depend on many design factors, such as the hardware configuration of the data processing system, the operating conditions and so on. The provision of the clock signal generator under program control allows great freedom in the choice of operating frequency.

The system clock signal frequency can be changed during operation at will by loading new control data, under program control into the register 30 for the programmable system clock signal generators formed from a programmable phase-locked loop stage 32 and a programmable frequency divider stage 34.

Corresponding programmable clock signal generators 19, 21 (formed by other groups of the REG, PPLL and PFD stages) in the clock signal generator 10 can generate the additional clock signals under program control in the same way.

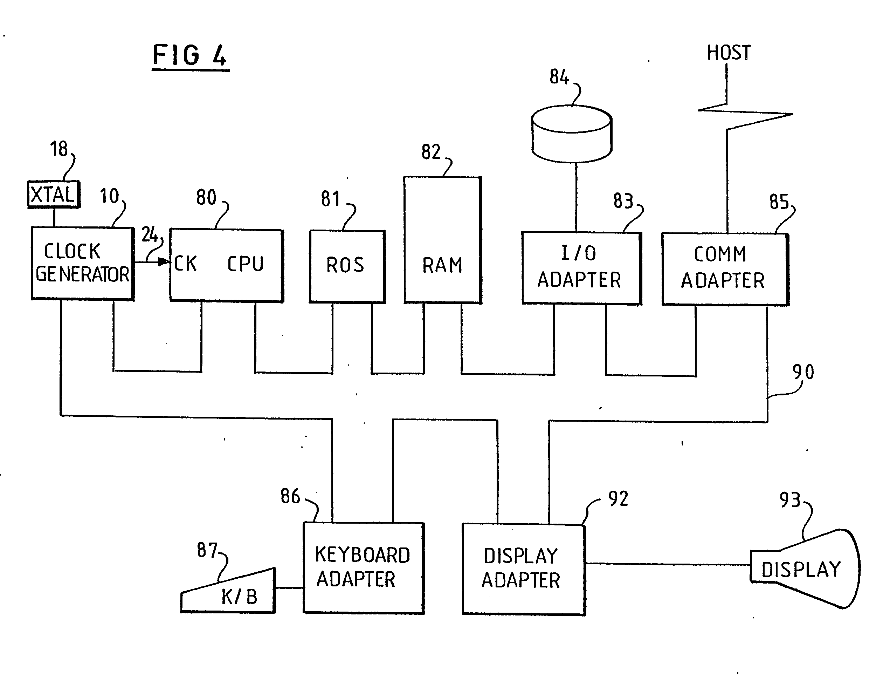

The invention is of general applicability to data processing systems. It can be used for generating the main system clock signal for a data processing system such as a personal computer as illustrated schematically in Figure 4.

Figure 4 illustrates a workstation comprising a central processing unit 80 (which could be the processor 12 of figure 1) in the form of a conventional multi-tasking processor and a number of other units connected thereto via a main system bus 90. Connected to the system bus are a random access memory RAM 82 and a read only store 81 (which could be the ROS 14 of Figure 1). An I/O adapter 83 is provided for connecting the system bus to the peripheral devices 84 such as disk units. Similarly, a communications adapter 85 is provided for connecting the workstation to external processors (e.g., a host computer). A keyboard 87 is connected to the system bus via a keyboard adapter 86. A display adapter 92 is used for controlling the display of data on a display device 93. A clock signal generator 10 is also connected to the bus 90 and is arranged to generate the processor clock signal 24 and other clock signals within the system.

The display adapter 92 could also include a clock signal generator such as the clock signal generator 10 for generating the clock signals internal to the display adapter. In this case the data processing system 26 shown in Figure 1 could form part of the display adapter with the bus 16 being the internal display adapter bus. The processor 12 of Figure 1 would in this case be a display adapter processor (which would additionally be connected to the main system bus 90) and the system clock signal is the system clock signal for the display processor. In this example, the additional programmable frequency generators can be used to generate programmable pixel clock signals and/or programmable clock signals controlling the display device and/or for scanning display data to the display device. Thus, the system can be configured under program control to generate all the clock signal frequencies which might be needed for the various display adapters which it might be desired to connect to the display adapter with a single, inexpensive crystal. This gives a degree of flexibility not previously attainable.

The clock signal generator 10 could be implemented in a dedicated integrated circuit. It could alternatively form part of a circuit for performing other functions. For example, if the clock signal generator is used to generate the clock signals for a display adapter, it is advantageous to incorporate the clock signal generator in a video interface chip so that high frequency pixel clock signals can be generated and kept internal to the chip.

Although an example of the present invention has been illustrated above, it will be appreciated that many modifications and additions are possible within the scope of the invention.

For example, although Figures 1 and 2 only show a single, programmable frequency divider (PFD) stage associated with a PPLL stage, a plurality of PFD stages could be associated with each PPLL stage, each PFD stage receiving the primary frequency 'P' output from the PPLL stage. The register 36 could be extended, or a second register provided whereby each of the plurality of PFD stages could be controlled to generate a different sub-harmonic of the frequency 'P' under program control. The PFD stages could also be arranged to further divide the frequency 'P' beyond P/8 to generate P/16, P/32 etc. as required, given more control bits in the register 36. With the additional of appropriate circuitry, they could also be arranged to generate: clock signal trains with different mark-space ratios (or duty cycles); non-binary sub-multiples of the frequency 'P' and sub-multiples of the frequency 'P' with different phase relationships.

In the specific example described, the reference frequency was 1 MHz generated from a 4 MHz source. It will, however, be appreciated that a source of a different frequency and/or a different frequency divider ratio in divider FD could be used to general different clock signal frequencies.

## Claims

1. Clock signal generator for generating the system clock signal (24) for the processor (12) of a data processing system (26), the clock signal generator comprising a programmable frequency generator (23) which is connectable (50) to a source of a fundamental frequency (18) for generating the system clock signal and which is connectable (38, 40) to receive control data from the processor under program control whereby the frequency of the system clock signal (24) for the processor is selectable in response to data supplied by the processor (12) under program control, characterised in that the clock signal generator comprises one or more additional programmable frequency generators (19, 21), each additional programmable frequency generator being connectable (50) to the source of a fundamental frequency (18) and connectable (38, 40) to receive control data from said processor under program control for generating an additional independent clock signal, the frequency (20, 22) of each of which is selectable in response to data supplied by said processor (12) under program control.

2. A clock signal generator as claimed in claim 1 wherein the or each programmable frequency generator comprises a programmable phase-locked loop (42, 44, 46) for generating a primary frequency (P).

3. A clock signal generator as claimed in claim 3 wherein the programmable phase-locked loop comprises a voltage controlled oscillator (46) for generating the primary frequency (P), a counter (42) for counting a number of cycles of said primary frequency, which number is determined by the control data, and for generating a control pulse on counting said number of cycles and a phase comparator (44) for comparing the phase of said control pulse to the phase of a reference frequency derived from said fundamental frequency, the phase comparator controlling the frequency of oscillation of the voltage controlled oscillator.

4. A clock signal generator as claimed in claim 2 or claim 3 wherein each programmable frequency generator comprises one or more programmable frequency dividers (34), each for selecting a sub-multiple of the primary frequency under program control as a separate clock signal output of that programmable frequency divider.

5. A clock signal generator as claimed in claim 4 wherein a programmable frequency divider (34) comprises a frequency divider chain (52, 54, 56) connected to receive the primary frequency (P) for generating sub-multiples of the primary frequency (P) and a multiplexer (58), responsive to the control data for selecting one of the submultiples of the primary frequency (P) under program control as the clock signal output of the programmable frequency generator.

6. A clock signal generator as claimed in any of claims 4 or 5 comprising means (60) for updating the selection of a sub-multiple of the primary frequency (P) by said multiplexer in synchronism with the slowest sub-harmonic input to the multiplexer.

7. A clock signal generator as claimed in any of the preceding claims wherein each programmable frequency generator comprises register means (36) for storing said control data.

8. A clock signal generator as claimed in any of the preceding claims wherein the programmable frequency generators are integrated in a single integrated circuit.

9. A data processing system comprising a system processor and a clock signal generator as claimed in any preceding claim.

10. A data processing system as claimed in claim 9 comprising control means (41, 43, 39) for initially setting the programmable frequency generator for generating said system clock signal to a predetermined initial frequency on system initialization, and stored system start-up code for, under processor control, changing said initial frequency to an operating frequency.

11. A data processing system as claimed in claim 9 or claim 10 in the form of a display adapter (92) for attachment of a display device (93) to the main bus (90) of a workstation, wherein the processor (12) is a display processor and wherein the system clock signal (24) is the system clock signal for the display processor, and wherein the clock signal generator (10) additionally generates programmable pixel clock signals and/or programmable clock signals controlling the display device and/or for scanning display data to the display device (93).

7

_FIG.1_

EP 0 385 567 A2

FIG. 2

FIG. 3

EP 0 385 567 A2

## FIG 4

EP 0 385 567 A2